# EUROPEAN PATENT SPECIFICATION

(11) **EP 2 482 133 B1**
(45) Date of publication and mention of the grant of the patent: **18.01.2017**
(21) Application number: 10818600.8
(22) Date of filing: 18.06.2010
(51) Int. Cl.: G03F 7/30, G03F 7/32

(54) **METHOD FOR PROCESSING WASTE SOLUTION IN PLATE-MAKING PROCESS OF PHOTOSENSITIVE LITHOGRAPHIC PRINTING PLATE**
VERFAHREN ZUR VERARBEITUNG EINER ABFALLLÖSUNG IN EINEM PLATTENVERSTELLUNGSVERFAHREN FÜR EINE LICHTEMPFINDLICHE LITHOGRAPHIEDRUCKPLATTE
PROCÉDÉ DE TRAITEMENT DE SOLUTION RÉSIDUELLE DANS UN PROCESSUS DE FABRICATION DE PLAQUES D'IMPRESSION LITHOGRAPHIQUE PHOTOSENSIBLES

(30) Priority: 25.09.2009 JP 2009220612
(43) Date of publication of application: 01.08.2012
(73) Proprietor: FUJIFILM Corporation, Tokyo 106-8620 (JP)
(72) Inventor: AOSHIMA, Norio, Haibara-gun Shizuoka 421-0396 (JP); WATANABE, Toshihiro, Haibara-gun Shizuoka 421-0396 (JP); KOBAYASHI, Fumikazu, Haibara-gun Shizuoka 421-0396 (JP)
(74) Representative: Hoffmann Eitle
(86) International application number: PCT/JP2010/060396
(87) International publication number: WO 2011/036923

(56) References cited:
- JP-A- 4 045 885
- JP-A- 5 142 781
- JP-A- 8 305 039
- JP-A- 11 290 868
- JP-A- 2004 070 031
- DATABASE WPI Week 199619 Thomson Scientific, London, GB; AN 1996-182742 XP002699665, & JP H08 57202 A (KONICA CORP) 5 March 1996 (1996-03-05)

## Description

### Technical Field

The present invention relates to a method for processing waste solution in the plate-making process of a photosensitive planographic printing plate. More specifically, the present invention relates to a method for processing waste solution in the plate-making process of a positive-working photosensitive planographic printing plate, when the plate-making process is carried out using a developer which does not contain a silicate but contains a non-reducing sugar and a base.

### Background Art

Heretofore, a cresol novolac resin has been used as a binder of an o-quinonediazide compound, which is a photosensitive component, in a photosensitive layer of a positive-working photosensitive planographic printing plate. Therefore, generally, a silicate which is a strong alkali having a pH of around 13 and is capable of dissolving the cresol novolac resin has been used in a developer.

Various alkali aqueous solutions are known as alkali aqueous solutions used as a developer for a positive-working photosensitive planographic printing plate as described above, but an aqueous silicate solution of sodium silicate, potassium silicate, or the like is most generally used. The reason for this is that it is possible to adjust the developability, to some extent, by adjusting the ratio of the amount of silicon oxide, which is a component of silicate, to the amount of alkaline metal oxide and the concentrations of silicon oxide and alkaline metal oxide. Further, to use an aqueous silicate solution is advantageous in that almost all positive-working photosensitive planographic printing plates need a strong alkali having a pH of around 13 for development, and silicate shows an excellent buffering action in this pH region and can realize stable development.

However, although silicate which is the main component of the developer is stable in the alkaline region, silicate has disadvantages in that it causes gelation and gets insoluble in the neutral region, and when silicate is evaporated to dryness, the resulting silicate dissolves only in a strong acid such as hydrofluoric acid. Actually, staining with solidified matters due to splashing of liquid in the vicinity of a developing tank of an automatic processor, deposition of insoluble matters due to neutralization when throwing away the waste developer, and the like may be described as the actual harm.

For example, Japanese Patent Application Laid-Open (JP-A) No. 58-95349 discloses a method of setting a sensor that electrically measures the degree of elusion of a photosensitive layer in a non-image area of a photosensitive plate and supplying a developer replenisher when the degree of elusion is decreased to a predetermined level. However, in a case in which the developer is a silicate type, there is a problem in that insoluble matters of silicate accumulate on the sensor to decrease the detection sensitivity, thus normal replenishment cannot be conducted, which results in remarkable deterioration in processing stability. In order to settle this problem, attempts of using an alkaline agent other than silicate in a developer for a positive-working photosensitive planographic printing plate have been made, and a strong alkali including trisodium phosphate or a combination of sodium hydroxide and trisodium phosphate has been evaluated as a developer, but all these strong alkalis have a weak buffering action, and stable development cannot be conducted.

In connection with the above problems, the inventors of the present invention have found that the combination of a sugar and a base shows a buffering action in the alkaline region, and have approached the problems described above by using a developer for a photosensitive planographic printing plate, the developer being characterized by containing at least one non-reducing sugar and at least one base without containing a silicate and by having a pH within the range of from 9.0 to 13.5 (see, for example, Japanese Patent No. 3642845).

Meanwhile, the process for processing a planographic printing plate by using an automatic processor includes a developing process of supplying a developer to an image forming layer to be processed, thereby imagewise eluting the image forming layer; a water washing process of washing out the developer; a fat-insensitizing process to protect the hydrophilic surface exposed; and a process of processing with a surface-regulating liquid so as to prevent the hydrophilic surface from being polluted with an organic substance at the time of a burning treatment.

In the case of processing a large number of planographic printing plate materials by using an automatic processor, means for supplying each replenisher to the processing solution of each process are adopted, in order to keep the concentrations of the components that are consumed during processing or components that volatile with time to be constant, and to maintain the performance of the processing solution which is lost due to the passage of time. In a case in which the performance of the processing solution is out of the acceptable range even though such replenishment is conducted, all the processing solutions are thrown away.

Due to the recent strengthening of pollution control by the Water Pollution Prevention Act or municipal ordinances, it becomes substantially impossible to throw away waste solutions such as those described above (waste solutions, for example, a developer, a water washing liquid, a gum liquid, a rinsing liquid, and the like) to a sewer. For this reason, plate-making traders pay a fee to waste disposal traders for collection of waste solutions, or provide a pollution processing equipment. However, the method of entrusting the duty to the waste disposal traders needs a large space for the storage of waste solutions, and needs a lot of money in terms of costs. Further, there are problems in that the pollution processing equipment needs an extremely high initial investment cost, a considerably vast place is needed for preparation, and the like.

As a countermeasure technique to the problems as described above, a technique of concentrating the waste processing solution by reducing the pressure and/or by heating, and cooling the liquid components that has been evaporated to be condensed, thereby separating the waste processing solution into a concentrate and a liquid component, to reduce the volume of waste by making it into the form of a concentrate, has been proposed.

For example, a method for collecting waste solution in a photosensitive planographic printing plate processing apparatus, in which the waste solution is dried and concentrated to reduce the amount of the waste solution, has been disclosed (see, for example, JP-A No. 05-341535). Further, a method of concentrating waste solution by heating under reduced pressure using an evaporator as a pressure-reducing means has been disclosed (see, for example, JP-A No. 01 -304463). Moreover, a method of concentrating waste solution by heating under reduced pressure using a heat pump circuit as a heating means has been disclosed (see, for example, Japanese Patent No. 3168015).

The methods described above each have a great effect on reducing the amount of waste processing solution and are useful means, but deposits are generated as the concentration proceeds, the viscosity gets higher or formation of an adhesive matter is caused, and the handling property when throwing away the concentrate liquid or the maintenance performance of the evaporative concentration container is insufficient.

Further, aiming at the reduction of the amount of deposits in the evaporative concentration container or suppressing formation of an adhesive matter, a technique of neutralizing the waste processing solution, adding an aggregating agent to aggregate the aggregation component, followed by filtration, and then sending the filtrate to an evaporative concentration container has been proposed (see, for example, JP-A No. 02-157084), however, there is a problem in that the aggregating agent costs.

### DISCLOSURE OF INVENTION

### Technical Problem

As described above, it is known that conventional waste developers containing a silicate cause gelation or become insoluble they are concentrated. Further, in waste developers that contain a large amount of organic solvent, the dissolved component may cause deposition when the organic solvent is removed by heating and concentration. The above elements both adhere to the inner wall of a container, a heater, or the like of a waste solution concentration equipment, and remarkably spoil the maintenance performance of the equipment, and thus, there has been a problem in that the concentration of waste solution lacks in practicability.

The present invention has been made in consideration of the above facts, and the object thereof is to provide a method for processing waste solution in the plate-making process of a photosensitive planographic printing plate, with which the maintenance performance of the equipment is excellent.

### Solution to Problem

<1> A method for processing waste solution in the plate-making process of a photosensitive planographic printing plate, which is discharged when the plate-making process is carried out using a developer for a photosensitive planographic printing plate, the method including evaporating and concentrating the waste solution using an evaporative concentration apparatus to separate the waste solution into water vapor and a dissolved component, wherein: the developer for a photosensitive planographic printing plate includes at least one sugar selected from non-reducing sugars and at least one base; and the method further includes heating the waste solution in the plate-making process using a heating means in an evaporation container having base resistance; taking out the water vapor separated from the waste solution in the plate-making process from the evaporation container, and condensing the water vapor in a cooling means, to turn the water vapor into reclaimed water.
   According to the invention described above, a method for processing waste solution in the plate-making process is provided, with which not only the amount of the waste solution is reduced by evaporating and concentrating the waste solution in the plate-making process using an evaporative concentration apparatus, but also the concentrate of the waste solution is less likely to adhere to the inside of the evaporation container or onto the surface of the heating means, because the waste solution does not contain a silicate, whereby the maintenance performance of the evaporative concentration apparatus is excellent.
<2> The method for processing waste solution in the plate-making process of a photosensitive planographic printing plate, the method including reducing the pressure inside the evaporation container using a pressure-reducing means, thereby heating and concentrating the waste solution in the plate-making process.
   According to the above invention, by reducing the pressure inside the evaporation container, the boiling point of the waste solution inside the container is lowered, and the waste solution is evaporated and concentrated at a temperature lower than that under the atmospheric pressure; and thus, a method for processing waste solution in the plate-making process, which is safe and with which the evaporation container, the waste solution, and the concentrate of the waste solution are less likely influenced by heat, may be provided.
<3> The method for processing waste solution in the plate-making process of a photosensitive planographic printing plate, wherein a heat pump is used as the heating means, and while the waste solution in the plate-making process is heated at a heat radiating portion of the heat pump, the water vapor in the cooling means is cooled at a heat absorbing portion of the heat pump.
   According to the above invention, heating and concentration of the waste solution is carried out using the heat radiation of a heat pump, and condensation of the water vapor is carried out using the heat absorption of the heat pump, and therefore the heat efficiency is good; and since the temperature does not get too high locally, the method is safer as compared with the method using an electric heater or the like; and further, since carbon dioxide is not discharged, the burden on the environment is reduced; thus, a method for processing waste solution in the plate-making process, which has good heat efficiency and is safe and with which the burden on the environment is little, may be provided.
<4> The method for processing waste solution in the plate-making process of a photosensitive planographic printing plate, the method further including neutralizing the waste solution in the plate-making process by lowering the pH.
   According to the above invention, since the pH of the waste solution is lowered by the neutralization treatment, a method for processing waste solution in the plate-making process may be provided, with which the evaporation container, the heating means, and the like are less likely influenced by strong alkali, and alkali less likely remains in the concentrate of the waste solution or in the reclaimed water to be discharged.
<5> The method for processing waste solution in the plate-making process of a photosensitive planographic printing plate, the method further including applying pressure, using a pump, to the concentrate of the waste solution in the plate-making process, which has been concentrated by evaporative concentration, and collecting the concentrate in a recovery tank.
   According to the above invention, the concentrate (slurry) which is obtained by evaporative concentration in an evaporation container while maintaining the fluidity, and has its volume reduced, is pressurized using a pump and is pressure-transferred to a recovery tank, and thus, it is not necessary to collect the slurry just under the evaporation container, and there is not limitation as to the volume of the recovery container and, as a result, it is possible to reduce the frequency of collection.
<6> A method for processing waste solution in the plate-making process of a photosensitive planographic printing plate, which is discharged when the plate-making process is carried out using a developer for a photosensitive planographic printing plate, the method including evaporating and concentrating the waste solution in the plate-making process using an evaporative concentration apparatus to separate the waste solution into water vapor and a dissolved component, wherein a content of organic solvent in the developer for a photosensitive planographic printing plate is 5% by mass or lower; and the method further includes heating the waste solution in the plate-making process using a heating means in an evaporation container having base resistance; taking out the water vapor separated from the waste solution in the plate-making process from the evaporation container, and condensing the water vapor in a cooling means, to turn the water vapor into reclaimed water. Advantageous Effects of Invention

By having the configuration described above, the present invention is capable of providing a method for processing waste solution in the plate-making process of a photosensitive planographic printing plate, with which the maintenance performance of the equipment is excellent.

### BRIEF DESCRIPTION OF DRAWINGS

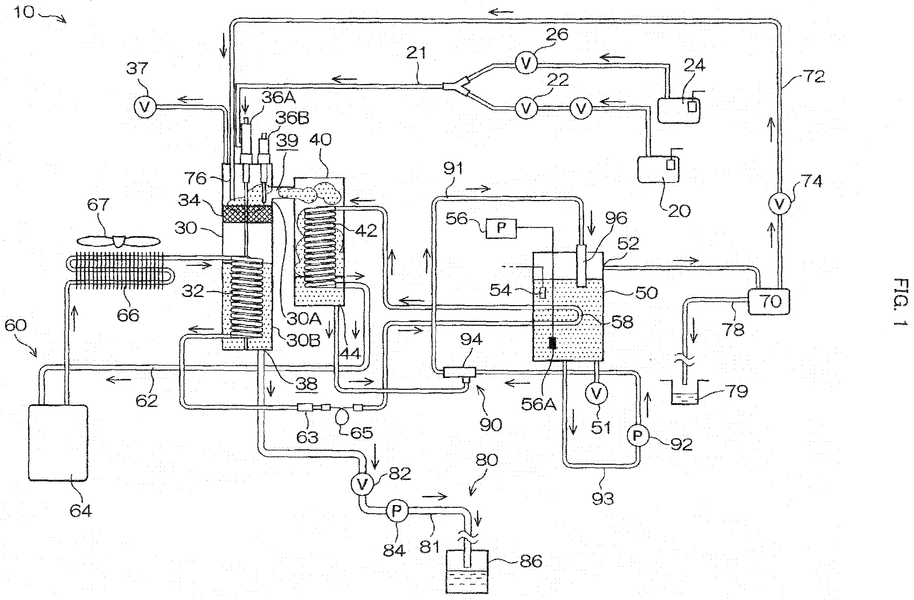

Fig. 1 is a schematic diagram showing the main portion of a waste solution processing apparatus according to an exemplary embodiment of the present invention.

### BEST MODE FOR CARRYING OUT THE INVENTION

Hereinbelow, an example of an exemplary embodiment according to the present invention is explained with reference to the drawing.

### <Entire Configuration>

As shown in Fig. 1, the waste solution processing apparatus 10 according to an exemplary embodiment of the present invention is provided with: a processing solution tank 20 which stores a waste developer that is discharged as the plate-making process of a photosensitive planographic printing plate is carried out; an evaporation container 30 which applies heat under reduced pressure to the waste solution that has been transferred from the processing solution tank 20, to thereby separate the waste solution into a water component to be evaporated and the remaining concentrate (slurry); a cooling container 40 into which the water component that has been separated as water vapor in the evaporation container 30 is introduced and in which the water vapor is cooled and condensed to be turned into reclaimed water; a reclaimed water tank 50 which stores the reclaimed water obtained by condensing in the cooling container 40; and a heat pump unit 60 which transfers heat between the inside of the evaporation container 30 and the inside of the cooling container 40.

As a pressure-reducing means in the evaporation container 30, a generally used mechanical vacuum pump of a water sealed type, an oil-sealed rotary type, a diaphragm type, or the like, a diffuser pump using oil or mercury, a compressor such as a multistage turbo compressor, a reciprocating compressor, or a screw compressor, and an aspirator may be exemplifies; and among them, an aspirator is preferably used in view of maintenance performance and costs. As the heating and cooling means, various kinds of heat exchangers may be used, and it is preferable to use a heat pump circuit from the viewpoint of running cost.

Further, it is preferable that the transfer of the waste processing solution to the waste solution processing apparatus 10, the transfer of the concentrate to a recovery tank 86, and the like are automatic liquid transfer using a means such as pump liquid transfer or an electromagnetic valve, for manpower saving. In the present invention, since a waste solution that does not contain a silicate is processed, the fluidity of the concentrate is maintained, and therefore, it is possible to transfer the liquid using a pump or the like, which is different from conventional methods.

When the reclaimed water that is stored in the reclaimed water tank 50 overflows, the reclaimed water is sent to a wash water tank 70, and a portion of this reclaimed water is used as wash water to wash the inside of the evaporation container 30. Further, a concentrate recovery pipeline 80 is connected to the bottom part of the evaporation container 30, and the concentrate is discharged to the outside. Moreover, a reclaimed water circulating device 90 is connected to the evaporation container 30 and the cooling container 40, and during the evaporative concentration operation, the pressure of the inside is reduced to a pressure lower than the atmospheric pressure. By the heating and pressure reducing means, the liquid temperature and the degree of vacuum inside the evaporation container 30 are kept, for example, at a liquid temperature of from 20°C to 35°C, and a degree of vacuum of from 2.6 kPa to 4.6 kPa, and evaporative concentration of the waste solution is carried out.

The evaporated solvent (water) is cooled in the cooling container 40, and is turned into reclaimed water having a low BOD value and a low COD value. In a case in which the developer used in the present invention is used, approximately, the BOD value is 300 mg/L or less and the COD value is 250 mg/L or less. The reclaimed water is transferred by an aspirator 94 to the reclaimed water tank 50, and is stored therein. Air is supplied to the reclaimed water tank 50 using an aeration pump 56, and the pH of the reclaimed water, that has a high pH value such that it is hard to throw away the reclaimed water as it is, is lowered by oxidation using carbon dioxide through supplying air, thereby adjusting the pH to make it easy to throw away. The supply amount of air is preferably, for example, 4,000 cm³/min or more.

When the amount of reclaimed water has reached a constant amount, the reclaimed water is discharged by overflow, and the reclaimed water is drained into a sewer or the like, or may be stored and used as water for washing the concentration container. With regard to washing of the concentration container, in the case of using, for example, a developer containing a silicate or an organic solvent at a content exceeding 1% by mass, deposits which are slightly soluble or have tackiness may be generated in the concentration container, and therefore it is necessary to disassemble and wash the apparatus whenever the apparatus is used. In contrast, in the case of using the developer used in the present invention, washing may be carried out by dipping in reclaimed water once a month for about one day, which is advantageous.

Hereinbelow, each processing section is explained.

### <Liquid Supply Section>

After development processing of a photosensitive planographic printing plate is carried out in a plate making processor which is not shown in the figure, for example, a developer is discharged as a waste solution in an amount according to the processing area of the photosensitive planographic plate that has been subjected to development processing. For example, the photosensitive planographic plate that has been exposed is dipped in a developing tank filled with a developer, to carry out development processing with respect to the surface (exposed face) of the photosensitive planographic plate.

As an example, automatic processors that are widely used recently in the plate-making and printing industries for the purpose of rationalization and standardization of the plate-making operations generally have a development portion and a post-treatment portion, and include a device that transports a printing plate, respective processing solution tanks, and spraying devices, and in which development processing is conducted in such a manner that respective pumped-up processing solutions are sprayed on the printing plate that has been exposed from spray nozzles, while horizontally transporting the printing plate. Further, lately, a processing method including conveying and dipping a printing plate in a processing solution tank filled with a processing solution by means of submerged guide rolls or the like is also known. In such automatic processing, processing may be performed while supplying each replenisher to each processing solution depending on the processing amounts, operation times, and the like. Moreover, a throw-away processing system which is a processing method of processing with substantially unused processing solutions may also be applied.

The waste solution generated as a result of the development processing as described above is stored in a waste solution tank or the like which is provided inside the automatic processor. However, it is necessary to routinely carry out waste solution processing. Thus, a configuration in which a portion of the waste solution which has been overflowed is collected in the processing solution tank 20 according to the present invention, a configuration in which a waste solution tank itself serves as the processing solution tank 20 according to the present invention, or the like is employed.

The waste solution may be sent from a waste solution tank, that is provided separately, to the processing solution tank 20 by manual labor or using a force feed pump or the like. Alternatively, in a case in which the processing solution tank 20 itself is a waste solution tank, a liquid level sensor which is not shown in the figure may be provided so as to prevent overflow of the waste solution from the processing solution tank 20.

As shown in Fig. 1, the processing solution tank 20 is equipped with a waste solution valve 22, and the waste solution is sent from the inside of the processing solution tank 20 to the evaporation container 30. The processing solution tank 20 may be arranged at a lower position than the position of the evaporation container 30, and a pump may be provided in place of the waste solution valve 22.

Anyway, in order to keep the liquid level in the evaporation container 30 described below to be within a predetermined range, operation control of the waste solution valve 22 or the pump is conducted in a control section which is not shown in the figure, according to the liquid level information of the waste solution in the evaporation container 30, which is sent from a normal liquid level sensor 36A and an abnormal liquid level sensor 36B, which are provided at the evaporation container 30.

An antifoaming agent tank 24 is provided in parallel with the waste solution tank 20, and an antifoaming agent is sent to the inside of the evaporation container 30 in accordance with the control of the control section, which is not shown in the figure. Specifically, an antifoaming agent valve 26 is provided in the middle of a pipe that sends the antifoaming agent from the antifoaming agent tank 24 to the evaporation tank 30, and the antifoaming agent valve 26 is switched on or off such that the antifoaming agent is added to the evaporation container 30 at a predetermined timing, for example, at the time of initiation of evaporative concentration operation in the evaporation container 30, thereby controlling the transfer of the liquid.

As the antifoaming agent, a known fluorine-containing or silicone-containing material is used, and particularly, a silicone-containing material is preferable. Commercially available products which are emulsified and dispersed materials may be used as the antifoaming agent, and those are available from Shin-Etsu Chemical Co., Ltd., Dow Corning Corporation, Toray Silicone Co., Ltd. (present Dow Corning Toray Silicone Co., Ltd.), and the like. For example, AF-A (trade name, manufactured by Fujifilm Corporation; a silicone-containing antifoaming agent emulsion) is preferably used. For example, AF-A (trade name) is diluted with water to a concentration of 5% by mass and then added to a waste developer. The addition amount of the diluted liquid is 5% by mass or less, and preferably 3% by mass or less, with respect to the waste developer. When the addition amount is too small, the waste developer foams in the evaporation container and, as a result, the working performance may be remarkably deteriorated. When the addition amount is too large, economic burden gets bigger, and the merit of concentration gets small.

### <Evaporation Container >

The processing solution tank 20 is connected to the evaporation container 30 via the pipe 21 through which the waste solution is sent. For example, the evaporation container 30 may be a sealed, oblong container having an approximately cylindrical shape, or the like, and the waste solution sent from the waste solution tank 20 is stored in the inside thereof. A heating coil 32 is provided inside the evaporation container 30, and the waste solution inside the container is heated, and the water component is evaporated as water vapor, whereby the water component in the waste solution is removed, and the volume of the waste solution is compressed.

The evaporation container 30 is communicated with the cooling container 40, which is described below, through a communicating path 39, and the pressure in the cooling container 40 is reduced by the reclaimed water circulating device 90 described below. Similarly, the pressure in the evaporation container 30, which is communicated with the cooling container 40 through the communicating path 39, is also reduced.

With regard to the heating coil 32, a part of the pipe that forms the heat pump unit 60 described below may be provided inside the evaporation container 30, or more simply, a heating means such as an electric heater may be used. As described above, since the pressure inside the heating container 30 is reduced by a pressure-reducing device, the boiling temperature of the waste solution (water contained in the waste solution) is lowered, and the water component evaporates at a temperature lower than that under the atmospheric pressure, whereby the water component is separated from the waste solution as water vapor.

Since the waste solution in the plate-making process of a photosensitive planographic printing plate used in the present invention is basic such that the pH thereof falls within the range of from 9.0 to 13.5, it is desirable that at least the wetted part of the evaporation container 30, in which the waste solution is evaporated and concentrated, is formed from a material having alkali resistance, for example, SUS 316 or the like, or at least the wetted portion is coated by an alkali-resistant material. With regard to the part which does not contact with the waste solution, a cheaper material, for example, SUS 304 or the like may be used instead.

The inside of the evaporation container 30 is divided into an upper part 30A and a lower part 30B by a demister 34 (a vapor-liquid separating means). The demister 34 is formed from a porous material, for example, a stainless steel wire mesh or the like, and gas such as water vapor permeates, but mist such as water solution droplets is caught therein. The pipe 21 sends the waste solution to the lower part 30B, and water vapor that is generated from the waste solution heated by the heating coil 32 which is provided at the lower part 30B permeates through the demister 34 and moves to the upper part 30A.

The upper part 30A is communicated with the upper part of the cooling container 40, which is provided in the vicinity thereof, through the communicating path 39. In general, the liquid level of the waste solution reaches the maximum amount at the time of initiation of the heating and compressing operation, and the highest position of the liquid level is let be at a position lower than the position of the communicating path 39. The water vapor which is generated from the heated waste solution and retained at the upper part 30A passes through the communicating path 39 and moves to the cooling container 40. An air blowing means such as a fan may be provided inside the communicating path 39.

As described above, a normal liquid level sensor 36A and an abnormal liquid level sensor 36B are provided, for example, at a cap part or the like of the upper part 30A. The normal liquid level sensor 36A detects the upper limit position of the waste solution level at the time of normal operation. At fixed time intervals, liquid transfer from the processing solution tank 20 is carried out, to fill the evaporation container with the waste processing solution until the liquid level reaches the position of the normal liquid level sensor 36A. Further, a temperature sensor, which is not shown in the figure, is provided in the vicinity of the bottom face of the lower part 30B, and in a case in which the waste solution is running short, the temperature sensor detects the change of temperature and sends a signal of lack of liquid to a control section, which is not shown in the figure, and the control section stops heating by the heating coil 32, thereby realizing a configuration for preventing heating (so-called heating an empty container) in the state of lack of waste solution.

Moreover, an air vent valve 37 is provided at the upper part 30A. When opening the evaporation container 30, in which the pressure is reduced during operation, at the time of finishing the operation or the like, first, the air vent valve 37 is opened so that the pressure inside the evaporation container 30 is allowed to be the atmospheric pressure to prevent back flow of the liquid.

The abnormal liquid level sensor 36B, that detects the liquid level at the lower position than the position of the communicating path 39, detects the waste solution level when abnormal foam is generated inside the evaporation container 30, and sends a liquid over-flow signal to a control section, which is not shown in the figure, and the control section stops heating by the heating coil 32, thereby realizing a configuration for preventing penetration of waste solution through the communicating path 39 to the cooling container 40.

### <Concentrate Recovery Pipeline>

The lower part 30B of the evaporation container 30 is provided with a concentrate discharge port 38 through which the waste solution concentrate (slurry) is discharged from the bottom part from the evaporation container 30. The discharge port is made have a configuration such that the opening and closing movement thereof is controllable by a control section using, for example, an electromagnetic valve or the like, which is not shown in the figure. The concentrate discharge port 38 is connected to the concentrate recovery pipeline 80, and the waste solution concentrate is sent to the recovery tank 86 through the concentrate recovery pipeline 80. The concentrate recovery pipeline 80 has a configuration in which a pipe 81 connects the concentrate discharge port 38 and the recovery tank 86, with a valve 82 and a pump 84 which are provided in the middle thereof, whereby the concentrate that has been discharged from the concentrate discharge port 38 is sucked and pressurized by the pump 84, and then pressure-transferred to the recovery tank.

The waste solution concentrate which is generated as a result of concentration of the waste solution in the plate-making processing of the photosensitive planographic printing plate which is used in the present invention less likely causes gelation, gets insoluble, or causes deposition of dissolved components, as described above. Thus, in the present invention, the waste solution is capable of being concentrated without loosing the fluidity thereof, and it is thus possible to pressure-transfer the concentrate to the recovery tank 86 by the concentrate recovery pipeline 80.

Further, a neutralizing agent addition device, which is not shown in the figure, may be provided at the recovery tank 86. Lowering of the pH of the concentrate is effective in terms of further reducing the costs for waste solution processing or enhancing the safety during handling of concentrates. It is preferable that the pH of the concentrate after addition of a neutralizing agent be from 11.0 to 12.5. When the pH is within this range, it is possible to lower the pH without generating precipitates or the like. As the neutralizing agent, compounds known as pH reducing agents may be used, and examples thereof include carbonates and compounds including a solid acid which are disclosed in JP-A No. 11-253969. The neutralizing agent preferably used in the present invention is an aqueous solution of citric acid, which is excellent in view of safety of the material, hardly exhibiting local and abrupt change in pH at the time of addition, easiness of supply in the form of a solution, costs, and the like.

### <Cooling Container >

The upper part 30A of the evaporation container 30 is communicated with the cooling container 40 by the communicating path 39. The water vapor that resides at the upper part 30A of the evaporation container 30 is pressurized by convection or heating, and then passes through the communicating path 39, and moves to the cooling container 40. An air blow means such as a fan may be provided inside the communicating path 39. Similarly to the evaporation container 30, the cooling container 40 may be a sealed, oblong container having an approximately cylindrical shape, or the like, and the water vapor that has passed through the communicating path 39 from the evaporation container 30 resides inside the cooling container.

It is desirable that the cooling container 40, like the evaporation container 30, is also formed from a material having alkali resistance, for example, SUS 316 or the like, or is coated by an alkali-resistant material. However, unlike the evaporation container 30, since a wetted part which directly contacts with a strong basic waste solution is not present in the cooling container, a cheaper material, for example, SUS 304 or the like may be used instead.

A cooling coil 42 is provided inside the cooling container 40, and at the cooled surface thereof, the water vapor is condensed, and is stored as reclaimed water at the bottom part of the cooling container 40.

With regard to the cooling coil 42, a part of the pipe that forms the heat pump unit 60 described below may be provided inside the cooling container 40, or more simply, a cooling means such as a cooling water circulating pipe may be used.

A drainage port 44 is provided at the bottom part of the cooling container 40, and is connected to the reclaimed water circulating device 90, which is described below. The aspirator 94 included in the reclaimed water circulating device 90 produces negative pressure, sucks the reclaimed water from the drainage port 44, takes out the reclaimed water from the bottom part of the cooling container 40, and at the same time, reduces the pressure inside the cooling container 40, whereby the pressure inside of the evaporation container 30 is also reduced through the communicating path 39, and the pressures of the cooling container 40, communicating path 39, and evaporation container 30 are maintained lower than the atmospheric pressure.

### <Reclaimed Water Tank>

The water vapor, that has been condensed in the cooling container 40 and has been turned into reclaimed water, is sucked by the reclaimed water circulating device 90 from the drainage port 44 and stored in the reclaimed water tank 50.

The reclaimed water tank 50 is equipped with, for example, an over-flow drainage port 52, and when the water level of the reclaimed water stored exceeds a constant value, a portion of the reclaimed water is sent to a wash water tank 70. Further, for example, a float level sensor 54 is equipped, which detects the amount of the reclaimed water in the reclaimed water tank 50 and sends the information of the amount of the reclaimed water to a control section, which is not shown in the figure. When the liquid level of the reclaimed water is at a position lower than the position of the cooling pipe 58, which is described below, the control section, which is not shown in the figure, may conduct control such as stopping the heating and compressing operation of the whole equipment to prevent raising the temperature of the cooling coil 42 or the like.

An aeration pump 56 is provided at the reclaimed water tank 50 and, for example, an air stone 56A is connected to the aeration pump 56. By applying air (external air) to the reclaimed water using the aeration pump 56, carbon dioxide and the like in the air dissolve in the reclaimed water, and the pH of the reclaimed water is lowered, resulting in reducing the burden on the environment at the time of discharge.

Alternatively, a configuration may be employed, in which, for example, a pH meter, which is not shown in the figure, is provided in the reclaimed water tank 50, the pH detected is sent as a pH value information to a control section, which is not shown in the figure, and when the pH value of the reclaimed water detected exceeds a predetermined value, the control section, which is not shown in the figure, allows the aeration pump 56 to operate.

Furthermore, a configuration may be employed in which a drain valve 51 is provided at the bottom part of the reclaimed water tank 50 so that the reclaimed water is capable of being arbitrarily released.

### <Reclaimed Water Circulating Device>

A reclaimed water circulating device 90 is connected to the drainage port 44 which is provided at the bottom part of the cooling container 40. The reclaimed water circulating device 90 is equipped with a water jet pump 92, an aspirator 94 that is connected to the water jet pump 92 and produces negative pressure by means of water flow, and pipes 91 and 93 that send the reclaimed water sucked by the aspirator 94 from the drainage port 44 to the reclaimed water tank 50.

The water jet pump 92 is connected with the reclaimed water tank 50 by the pipe 93, and sucks the reclaimed water in the reclaimed water tank 50, and pressure-transfers the reclaimed water to the aspirator 94. The aspirator 94 produces negative pressure using the pressure of the reclaimed water which is pressure-transferred, and sucks the reclaimed water to pass through the pipe 91 from the cooling container 40 via the drainage port 44. The reclaimed water which has been pressure-transferred from the aspirator 94 toward the reclaimed water tank 50 is sent back to the reclaimed water tank 50 through a water supply port 96, and a portion thereof is sent to the wash water tank 70 from the over-flow drainage port 52, while another portion thereof is sent again to the water jet pump 92 through the pipe 93, and produces negative pressure at the aspirator 94.

### <Heat Pump Unit>

For heating the heating coil 32 provided inside the evaporation container 30 and for cooling the cooling coil 42 provided inside the cooling container 40, for example, the two coils may be combined, and a heat pump unit 60 that circulates a cooling medium through the inside thereof may be provided.

In the heat pump unit 60, the cooling medium, that circulates through the inside thereof, releases heat at the heating coil 32 provided inside the evaporation container 30 to apply heat to the waste solution, is cooled in the cooling pipe 58 that is dipped in the reclaimed water of the reclaimed water tank 50 and turns into a liquid, then absorbs the heat from its surroundings at the cooling coil 42 provided inside the cooling container 40 and turns into gas, and thereafter is transferred to a compressor 64 to be compressed and turns again into a liquid.

Specifically, the cooling medium in the form of gas which has come back to the compressor 64 through a pipe 62, is compressed by the compressor 64 and turns into a liquid. As the result of this operation, the temperature of the cooling medium increases. Therefore, the cooling medium that has turned into a liquid is cooled by a heat radiator 66 to a desired temperature in order not to overheat the inside of the evaporation container 30. The heat radiator 66 may have a configuration in which, for example, a heat radiator 66 that is provided with a cooling fin is combined with a cooling fan 67.

The liquid cooling medium releases heat when the cooling medium passes through the heating coil 32 inside the evaporation container 30, and applies heat to the surrounding waste solution. However, by heating with the heat released in this process, the temperature of the waste solution inside the evaporation container 30 is not raised to a temperature higher than the temperature of the cooling medium. Therefore, danger of overheating or the like is little as compared with a case in which another heating means such as a heater or the like is used.

The cooling medium that has released heat and has its temperature lowered is dehumidified while passing through, for example, a drier 63. Then, the cooling medium is rapidly expanded by utilizing the wire drawing that is generated by passing through inside a narrow capillary 65, followed by jetting into a wide pipe 62, to be turned into a low temperature and low pressure liquid, and is further cooled while passing through the cooling pipe 58 that runs through the reclaimed water in the reclaimed water tank 50. A configuration in which a strainer is provided at the upstream side of the capillary 65 to remove foreign substances may also be adopted.

The cooled cooling medium absorbs heat from the surrounding water vapor when passing through the cooling coil 42 provided inside the cooling container 40, whereby the water vapor in the surroundings of the cooling container 42 is condensed, and the resulting reclaimed water is stored inside the cooling container 40. By the heat that is absorbed from the water vapor, the cooling medium vaporizes and goes back to the compressor 64 again.

As to the cooling medium, it is desirable to select an alternative to Flon, HFC (such as R410A. R407C, or the like) having a low ozone depleting potential, but from the viewpoint of the global warming potential, ammonia, isobutane, carbon dioxide, or the like may be used.

### <Wash Water Tank>

Since the reclaimed water that has been sent from the over-flow drainage port 52 of the reclaimed water tank 50 to the wash water tank 70 has a sufficient low pH, owing to the supply of air by the aeration pump 56, it is possible to discharge the reclaimed water as it is to a drainage canal 79 (a sewer or the like) via a pipe 78.

Further, a configuration may be employed in which the reclaimed water is sent to the evaporation container 30 through a pipe 72 via a wash water pump (or a valve) 74, and the reclaimed water is then supplied to the inside of the evaporation container 30 from a water supply port 76. By washing the inside of the evaporation container 30, especially, the surface of the heating coil 32, with the reclaimed water supplied from the water supply port 76 at the time of completion of operation, lowering of efficiency at the time of heating and compressing operation is prevented.

Alternatively, a configuration may be employed in which the operation is stopped at fixed intervals, and the inside of the evaporation container 30 is washed with the reclaimed water, thereby preventing the adhesion of the concentrate to the inner wall of the evaporation container 30 or to the surface of the hating coil 32, and preventing clogging of the demister 34 or the like.

### <Capacity>

In a case in which the developer used in the present invention is used, it is possible to conduct concentration at maximum 1/5 to 1/8 in volume without generation of deposits or the like. The capacity is preferably from 2 L/hour to 4 L/hour. When a higher capacity than the above is set, the volume of the concentration container or the like has to be enlarged, and thus, the installation area may get larger and the cost for introducing the equipment may become higher, which is not preferable.

### <Developer >

In the method for processing waste solution in the plate-making process of the present invention, alkaline developers which contain an organic compound having a buffering action and a base as the main components, and do not substantially contain silicon dioxide should be used as the developer and replenisher used for the development of a photosensitive planographic printing plate. In the present invention, hereinafter, such developers are referred to as "non-silicate developers". It should be noted that the term "substantially" means that the existence of an extremely small amount of silicone dioxide as an inevitable impurity or by-product is pennitted.

In the following, the developer for a planographic printing plate according to the present invention is described in detail. It should be noted that, in this specification, the term "developer" means a development initiating solution (a developer in the narrow sense) and a developer replenisher, unless otherwise specified.

### [Non-Reducing Sugar and Base]

Conventionally, an aqueous solution of silicate such as sodium silicate or potassium silicate is most generally used as the developer for a photosensitive planographic printing plate. The reason for this is that it is possible to adjust the developability, to some extent, by adjusting the ratio of the amount of silicon oxide SiO₂, which is a component of silicate, to the amount of alkaline metal oxide M₂O (generally, the ratio is expressed by a molar ratio of [SiO₂]/[M₂O]) and the concentrations of silicon oxide and alkaline metal oxide. Further, it is because almost all positive working photosensitive planographic printing plates need a strong alkali having a pH of around 13 for development, and silicate is capable of exerting an excellent buffering action in this pH region and realizing stable development. However, although silicate which is the main component is stable in the alkaline region, silicate has disadvantages in that it causes gelation and gets insoluble in the neutral region, and when silicate causes deposition by evaporation to dryness, the resulting silicate dissolves only in a strong acid such as hydrofluoric acid. Accordingly, in the process of concentrating the waste processing solution thereof, silicate may become insoluble and cause deposition, and therefore, it is necessary to move the concentrate liquid to another container or to remove the silicate which becomes insoluble in order to carry out the concentration processing successively, whereby the maintenance performance of the concentration apparatus is remarkably deteriorated.

In contrast, the developer used in the present invention includes at least one compound selected from non-reducing sugars and at least one base as its main components. The developer is used after adjusting the pH of the liquid to be within the range of from about 9.0 to about 13.5.

Such non-reducing sugars are sugars which do not have a free aldehyde group or ketone group and do not show reducing properties. The non-reducing sugars are classified into trehalose type oligosaccharides in which the reducing groups are bonded to each other, glycosides in which the reducing group of a sugar is bonded to a non-sugar, and sugar alcohols obtained by reduction of sugars by hydrogen addition, and any of them is preferably used in the present invention. Examples of the trehalose type oligosaccharides include saccharose and trehalose, and examples of the glycosides include an alkyl glycoside, a phenol glycoside, and a mustard oil glycoside. Further, examples of the sugar alcohols include D,L-arabit, ribit, xylit, D,L-sorbit, D,L-mannit, D,L-idit, D,L-talit, dulcit, and allodulcit. Moreover, multitols obtained by hydrogen addition of disaccarides and reduced products (reduced starch syrup) obtained by hydrogen addition of oligosaccharides are preferably used. Among them, preferable non-reducing sugars that may be used in the developer according to the present invention are sugar alcohols or saccharose, and particularly, D-sorbit, saccharose, and reduced starch syrup are preferable in terms of buffering action in an appropriate pH region and low cost.

These non-reducing sugars may be used alone or in a combination of two or more of them, and the proportion thereof is preferably from 0.1% by weight to 30% by weight, and more preferably from 1% by weight to 20% by weight, of the developer. When the concentration is lower than this range, a sufficient buffering action is not obtained, and when the concentration is higher than this range, it is difficult to realize high concentration, and the problem of increasing the cost may be caused.

In a case in which a reducing sugar is used in combination with a base, the color changes to brown with the lapse of time, and also the pH decreases gradually, and therefore, there is a problem in that the developability deteriorates.

As the base which is used in combination with the non-reducing sugar, a conventionally known alkali agent may be used. Examples thereof include inorganic alkali agents such as sodium hydroxide, potassium hydroxide, lithium hydroxide, trisodium phosphate, tripotassium phosphate, triammonium phosphate, disodium phosphate, dipotassium phosphate, diammonium phosphate, sodium carbonate, potassium carbonate, ammonium carbonate, sodium hydrogencarbonate, potassium hydrogencarbonate, ammonium hydrogencarbonate, sodium borate, potassium borate, or ammonium borate. Further, an organic alkali agent such as monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, or pyridine may also be used.

These alkali agents may be used alone or in a combination of two or more of them. Among the alkali agents, sodium hydroxide and potassium hydroxide are preferable. The reason for this is that the pH adjustment becomes possible in a wider pH region by adjusting the amount of the alkali agent with respect to the amount of the non-reducing sugar. Further, trisodium phosphate, tripotassium phosphate, sodium carbonate, potassium carbonate, and the like are also preferable, since they themselves have buffering action.

The alkali agent is added such that the pH of the developer falls within the range of from 9.0 to 13.5, and the addition amount thereof is determined depending on the desired pH and the kind and addition amount of the non-reducing sugar. The pH range is more preferably from 10.0 to 13.2.

In the developer according to the present invention, an alkaline buffer solution including a weak acid other than a sugar and a strong base may also be used. The weak acid used in such a buffer solution is preferably an acid having a dissociation constant (pKa) of from 10.0 to 13.2. Such a weak acid is selected from those described in "IONIZATION CONSTANTS OF ORGANIC ACIDS IN AQUEOUS SOLUTION" published by Pergamon Press Inc., and the like, and examples include alcohols such as 2,2,3,3-tetralluoro-1-propanol (pKa 12.74), trifluoroethanol (pKa 12.37), or trichloroethanol (pKa 12.24); aldehydes such as pyridine-2-aldehyde (pKa 12.68) or pyridine-4-aldehyde (pKa 12.05); compounds having a phenolic hydroxyl group such as salicylic acid (pKa 13.0), 3-hydroxy-2-naphthoic acid (pKa 13.84), catechol (pKa 12.6), gallic acid (pKa 12.4), sulfosalicylic acid (pKa 11.7), 3,4-dihydroxysulfonic acid (pKa 12.2), 3,4-dihydroxybenzoic acid (pKa 11.94), 1,2,4-trihydroxybenzene (pKa 11.82), hydroquinone (pKa 11.56), pyrogallol (pKa 11.34), o-cresol (pKa 10.33), resorcinol (pKa 11.27), p-cresol (pKa 10.27), or m-cresol (pKa 10.09); oximes such as 2-butanone oxime (pKa 12.45), acetoxime (pKa 12.42), 1,2-cycloheptanedione dioxime (pKa 12.3), 2-hydroxybenzaldehyde oxime (pKa 12.10), dimethylglyoxime (pKa 11.9), ethanediamidodioxime (pKa 11.37), or acetophenone oxime (pKa 11.35); nucleic acid-relating substances such as adenosine (pKa 12.56), inosine (pKa 12.5), guanine (pKa 12.3), cytosine (pKa 12.2), hypoxanthine (pKa 12.1), or xanthine (pKa 12.9); and other weak acids such as diethylaminomethylphosphonic acid (pKa 12.32), 1-amino-3,3,3-trifluorobenzoic acid (pKa 12.29), isopropylidenediphosphonic acid (pKa 12.10), 1,1-ethylidenediphosphonic acid (pKa 11.54), 1-hydroxyethylidene-1,1-diphosphonic acid (pKa 11.52), benzimidazole (pKa 12.86), thiobenzamide (pKa 12.8), picolinethioamide (pKa 12.55), or barbituric acid (pKa 12.5).

Among these weak acids, sulfosalicylic acid and salicylic acid are preferable. As the base that is used in combination with the weak acid, sodium hydroxide, ammonium 1-hydroxide, potassium hydroxide, or lithium hydroxide is preferably used. These alkali agents may be used alone or in a combination of two or more of them.

The various alkali agents described above are used such that the pH falls within the preferable ranges, by changing the concentration and combination thereof.

### [Surfactant]

To the developer according to the present invention, various kinds of surfactants or organic solvents may be added, as required, for the purposes of accelerating the developability, dispersing developer scum, and enhancing the ink affinity of the image areas of the printing plates. Preferable examples of the surfactants include anionic, cationic, nonionic, and amphoteric surfactants.

Preferable examples of the surfactants include nonionic surfactants such as polyoxyethylene alkyl ethers, glycerin fatty acid partial esters, sorbitan fatty acid partial esters, sucrose fatty acid partial esters, fatty acid diethanolamides, polyoxyethylene alkylamines, triethanolamine fatty acid esters, or trialkylamine oxide; anionic surfactants such as fatty acid salts, dialkylsulfosuccinic acid ester salts, straight-chain alkylbenzenesulfonic acid salts, polyoxyethylene alkyl sulfophenyl ether salts, sulfuric acid ester salts of fatty acid alkyl ester, or polyoxyethylene alkyl ether sulfuric acid ester salts; cationic surfactants such as alkylamine salts, quaternary ammonium salts such as tetrabutylammonium bromide, polyoxyethylene alkylamine salts, or polyethylene polyamine derivatives; and amophoteric surfactants such as carboxybetaines, aminocarboxylic acids, sulfobetaines, aminosulfuric acid esters, or imidazolines.

More preferable surfactants are fluorine-containing surfactants containing a perfluoroalkyl group in the molecule thereof. Examples of such fluorine-containing surfactants include anionic surfactants such as perfluoroalkycarboxylic acid salts, perfluoroalkylsulfonic acid salts, or perfluoroalkylphosphoric acid esters; amphoteric surfactants such as perfluoroalkylbetaines; cationic surfactants such as perfluoroalkyl trimethyl ammonium salts; and nonionic surfactants such as perfluoroalkylamine oxide, perfluoroalkyl ethyleneoxide adducts, oligomers containing a perfluoroalkyl group and a hydrophilic group, oligomers containing a perfluoroalkyl group and a lipophilic group, oligomers containing a perfluoroalkyl group, a hydrophilic group, and a lipophilic group, or urethanes containing a perfluoroalkyl group and a lipophilic group.

The above surfactants may be used alone or in a combination of two or more of them, and the surfactant is added to the developer in an amount in a range of from 0.001% by weight to 10% by weight, and more preferably from 0.01% by weight to 5% by weight.

When the amount of the surfactant is too large, the surfactant may foam in the distillation process, resulting in spoiling the stability of the concentration operation, and further, it is troublesome since the equipment is widely polluted by the waste processing solution. When the amount of the surfactant is too small, the developability may be deteriorated, and developer scum derived from the image forming layer may be generated in the developer, resulting in exerting influence on the durability of the developer.

### [Development Stabilizer]

In the developer according to the present invention, various kinds of development stabilizers are used. Preferable examples thereof include polyethylene glycol adducts of sugar alcohols described in JP-ANo. 6-282079, tetraalkylammonium salts such as tetrabutylammonium hydroxide, phosphonium salts such as tetrabutylphosphonium bromide, and iodonium salts such as diphenyliodonium chloride.

### [Organic Solvent]

To the developer, an organic solvent is further added, as necessary, in order to ensure developability. Such an organic solvent suitably has a solubility in water of about 10% by mass or lower, and is preferably selected from organic solvents having a solubility in water of 5% by mass or lower. Examples thereof may include 1-phenylethanol, 2-phenylethanol, 3-phenyl-1-propanol, 2-phenoxyethanol, 2-benzyloxyethanol, benzyl alcohol, cyclohexanol, and N-phenylethanolamine. The content of the organic solvent is 5% by mass or lower with respect to the total weight of the liquids to be used. The content is more preferably 1% by mass or lower. When the content is too large, the amount of the surfactant as a plasticizer needs to be increased, which is not preferable. Further, when the organic solvent is evaporated in the concentration process of the waste processing solution, the component of the image forming layer whose solubility in a developer has been ensured by the existence of the organic solvent may cause deposition, and there is a concern for generation of sludge, resulting in remarkably deteriorating the maintenance performance of the concentration apparatus.

### [Reducing Agent]

To the developer according to the present invention, a reducing agent may further be added. The reducing agent acts to prevent staining of the printing plate. Preferable examples of an organic reducing agent include phenol compounds such as hydroquinone or resorcin, and amine compounds such as phenylenediamine or phenylhydrazine. Further, preferable examples of an inorganic reducing agent may include sodium salts, potassium salts, and ammonium salts of an inorganic acid such as sulfurous acid, hydrosulfurous acid, phosphorous acid, hydrophosphorous acid, dihydrophosphorous acid, thiosulfuric acid, or dithionous acid. Among these reducing agents, sulfurous acid salts are especially excellent in a staining prevention effect. When the reducing agent is used, the reducing agent is preferably contained in an amount in a range of from 0,05% by mass to 5% by mass with respect to the developer at the time of use.

### [Other Additives]

Further, known additives may be further added, as necessary, to the developer according to the present invention. For example, an organic carboxylic acid, an antiseptic, a coloring agent, a thickener, an antifoaming agent, a water softener, or the like may be incorporated in the developer.

### [Water]

The remainder component (balance) of the developer is water. It is advantageous in transportation to form the developer according to the present invention as a concentrate liquid, in which the content of water is lower than that at the time of use, and dilute the concentrate liquid with water at the time of use. In this case, the concentration degree is suitably such extent that the respective components do not cause separation or deposition.

Moreover, in a case in which development is performed using an automatic processor, it is known that a large number of planographic printing plates can be processed without exchanging the developer in the developing tank for a long time by adding an aqueous solution (replenisher) having a higher alkali strength than that of the developer to the developer. In the present invention, this replenishment system is preferably employed. To the developer and replenisher, various kinds of surfactants or organic solvents may be added, as required, for the purposes of accelerating and inhibiting the developability, dispersing developer scum, and enhancing the ink affinity of the image areas of the printing plates. Preferable examples of the surfactants include anionic, cationic, nonionic, and amphoteric surfactants. Further, to the developer and replenisher, as required, a reducing agent such as hydroquinone, resorcin, or a sodium salt or potassium salt of an inorganic acid such as sulfurous acid, hydrosulfurous acid, or the like, and further, an organic carboxylic acid, an antifoaming agent, or a water softener may also be added.

### <Planographic Printing Plate>

Hereinbelow, a planographic printing plate to which the developer according to the present invention is preferably applicable is described in detail.

### [Positive-working Planographic Printing Plate]

The positive-working planographic printing plate (also referred to as the "planographic printing starting plate") which is used in the plate-making method of the present invention is provided with an image recording layer, that contains an alkali-soluble resin and an infrared absorbing dye, and further contains, as desired, a dissolution inhibitor or the like, on a support.

Hereinbelow, the configuration of the image recording layer is described.

### [Infrared Absorbing Dye]

In the present invention, the infrared absorbing dye used in the image recording layer is not particularly limited, as long as it is a dye that absorbs infrared rays and generates heat, and various types of dyes known as infrared absorbing dyes may be used.

As the infrared absorbing dye, commercially available dyes and known dyes described in literatures (for example, "SENRYO BINRAN (Dye Handbook)", edited by The Society of Synthetic Organic Chemistry, Japan, 1970) may be used. Specific examples of the infrared absorbing dye include an azo dye, a metallic complex salt azo dye, a pyrazolone azo dye, a quinoneimine dye, a methine dye, and a cyanine dye. In the present invention, among these dyes, dyes that absorb infrared light or near infrared light are particularly preferable from the viewpoint of use with lasers emitting infrared light or near infrared light.

The infrared absorbing dye which is usable in the present invention may be used without particular limitation as to the absorption wavelength region, as long as it is a substance that absorbs the light energy radiation to be used for recording and generates heat. Infrared absorbing dyes or pigments having absorption maximum in a wavelength region of from 800 nm to 1200 nm are preferable from the viewpoint of compatibility with high-output lasers which are easily available.

As the dye, commercially available dyes and known dyes described, for example, in "SENRYO BINRAN (Dye Handbook)" (edited by The Society of Synthetic Organic Chemistry, Japan, 1970), and the like may be used. Specific examples thereof include those described in paragraphs [0050] to [0051] of JP-A No. 10-39509.

Among these dyes, a cyanine colorant, a squarylium colorant, a pyrylium salt, and an organic metal complex (for example, a dithiolato complex or the like) are particularly preferable. From the viewpoint of interaction formability with an alkali soluble resin, a cyanine dye represented by Formula (1) in JP-A No. 2001-305722 is preferable.

The amount of the infrared absorbing dye added to the image recording layer is from 0.01% by mass to 50% by mass, preferably from 0.1% by mass to 50% by mass, and particularly preferably from 0.1% by mass to 30% by mass, with respect to the mass of the image recording layer, from the viewpoints of sensitivity and uniformity of the image recording layer.

### [Alkali-Soluble Resin]

The alkali-soluble resin used in the image recording layer is a water-insoluble and alkali water-soluble resin (hereibelow, referred to as an "alkali-soluble polymer" as appropriate), and encompasses a homopolymer including an acidic group in the main chain and/or the side chain of the polymer, a copolymer thereof, and a mixture thereof. Accordingly, the image recording layer of the planographic printing starting plate has a property of dissolving when contacting with an alkaline developer.

The alkali-soluble polymer used in the image recording layer is not particularly limited as long as it is a conventionally known polymer, but is preferably a polymer compound having, in the molecule, any of (1)a phenolic hydroxyl group, (2) a sulfonamido group, or (3) an active imido group, as a functional group. Above all, a polymer compound having (1) a phenolic hydroxyl group in the molecule is preferred.

More specifically, the polymer described in paragraphs [0023] to [0042] of JP-A No. 2001-305722 is preferably used.

Examples of the polymer compound having (1) a phenolic hydroxyl group include a novolac resin such as a phenol formaldehyde resin, an m-cresol formaldehyde resin, a p-cresol formaldehyde resin, an m-/p-mixed cresol formaldehyde resin, or a phenol/cresol (which may be any of m-, p-, or m-/p-mixed) mixed formaldehyde resin; and a pyrogallol acetone resin. As the polymer compound having a phenolic hydroxyl group other than the above, it is preferable to use a polymer compound having a phenolic hydroxyl group in a side chain thereof. Examples of the polymer compound having a phenolic hydroxyl group in a side chain thereof include polymer compounds obtained by homopolymerization of a polymerizable monomer that includes a low molecular weight compound having one or more phenolic hydroxyl groups and one or more polymerizable unsaturated bonds, and polymer compounds obtained by copolymerization of the monomer and another polymerizable monomer.

Examples of the polymer compound having (2) a sulfonamido group include polymer compounds obtained by homopolymerization using a polymerizable monomer having a sulfonamido group, and polymer compounds obtained by copolymerization of the monomer and another polymerizable monomer. Examples of the polymerizable monomer having a sulfonamido group include a polymerizable monomer that includes a low molecular weight compound having, in one molecule, one or more sulfonamido groups -NH-SO₂-, in which at least one hydrogen atom is bonded to the nitrogen atom, and one or more polymerizable unsaturated bonds. Above all, a low molecular weight compound having an acryloyl group, an allyl group, or a vinyloxy group, and a substituted or monosubstituted aminosulfonyl group or a substituted sulfonylimino group is preferable.

The alkali-soluble polymer compound having (3) an active imido group is preferably a polymer compound having an active imido group in the molecule. Examples of this polymer compound include polymer compounds obtained by homopolymerization of a polymerizable monomer that includes a low molecular weight compound having, in one molecule, one or more active imido groups and one or more polymerizable unsaturated bonds, and polymer compounds obtained by copolymerization of the monomer and another polymerizable monomer.

When the alkali-soluble polymer is a copolymer obtained by copolymerization using the polymerizable monomer having a phenolic hydroxyl group, the polymerizable monomer having a sulfonamido group, or the polymerizable monomer having an active imido group and another polymerizable monomer, it is preferable that the monomer that imparts alkali solubility is contained in an amount of 10 mol% or more, and it is more preferable that the monomer that imparts alkali solubility is contained in an amount of 20 mol% or more, in order to realize sufficient alkali solubility and sufficiently achieve the effect of enhancing development latitude.

In the present invention, in a case in which the alkali-soluble polymer is a homopolymer or a copolymer obtained by using the polymerizable monomer having a phenolic hydroxyl group, the polymerizable monomer having a sulfonamido group, or the polymerizable monomer having an active imido group, the weight average molecular weight of the homopolymer or copolymer is preferably 2,000 or more, and the number average molecular weight thereof is preferably 500 or more. More preferably, the weight average molecular weight is from 5,000 to 300,000, the number average molecular weight is from 800 to 250,000, and the dispersity (weight average molecular weight/number average molecular weight) is from 1.1 to 10.

Further, in a case in which the alkali-soluble polymer in the present invention is a resin such as a phenol formaldehyde resin or a cresol aldehyde resin, the weight average molecular weight of the resin is preferably from 500 to 20,000, and the number average molecular weight thereof is preferably from 200 to 10,000.

One type of these alkali-soluble polymer compounds may be used alone, or two or more types of them may be used in combination, and the addition amount thereof is from 30% by mass to 99% by mass of the total solids content of the image forming layer, more preferably from 40% by mass to 95% by mass, and particularly preferably from 50% by mass to 90% by mass. The above range of content is appropriate from the viewpoints of both durability and sensitivity of the image forming layer.

It is preferable that the image recording layer contains a dissolution inhibitor from the viewpoint of sensitivity. There is no particular limitation to the dissolution inhibitor, and examples thereof include quaternary ammonium salts and polyethylene glycol compounds.

When the above measure for the improvement in inhibition (solubility inhibition) is conducted, lowering of the sensitivity occurs. In this case, addition of a lactone compound is useful. Concerning the lactone compound, it is thought that, when a developer penetrates to the exposed area, the developer is allowed to react with the lactone compound, and by this reaction, a carboxylic acid compound is newly generated, which makes contribution to the dissolution of the exposed area, resulting in enhancing the sensitivity.

Further, use of a substance such as an onium salt, an o-quinonediazide compound, an aromatic sulfone compound, or an aromatic sulfonic acid ester compound, which has a thermal decomposition property and is capable of substantially lowering the solubility of the alkali water soluble polymer compound in an undecomposed state, is preferable in view of improvement in the property to inhibit dissolution of the image areas to the developer. Examples of the onium salt include a diazonium salt, an ammonium salt, a phosphonium salt, an iodonium salt, a sulfonium salt, a selenonium salt, and an arsonium salt.

As other additives, it is preferable to add, for example, compounds such as a sensitivity adjusting agent, a printing-out agent, or a dye described in paragraphs [0024] to [0027] of JP-A No. 7-92660 or a surfactant for improving coatability as described in paragraph [0031] of JP-A No. 7-92660. Preferable examples of other preferable surfactants include compounds described in paragraphs [0053] to [0059] of JP-A No. 2001-305722.

### [Coating Amount]

The coating amount (solids content) of the image recording layer varies depending on the intended use. From the viewpoints of film-forming property and print resistance, the image recording layer may be provided with a coating amount of from 0.3 g/m² to 3.0 g/m², preferably from 0.5 g/m² to 2.5 g/m², and more preferably from 0.8 g/m² to 1.6 g/m².

The image recording layer of a planographic printing starting plate may have a monolayer structure, or may have a multilayer structure in which plural recording layers are laminated. Examples of the image recording layers of a multilayer structure include recording layers as described in JP-A No. 11-218914.

The image recording layers of a multilayer structure is explained. The image recording layers of a multilayer structure may have a multilayer configuration of at lest two or more layers (hereinbelow, for convenience, the case of two layers including an upper layer and a lower layer is explained).

For the alkali-soluble resin that forms the upper layer and the lower layer, the alkali-soluble resin explained above may be used. It is preferable that the upper layer has a lower solubility in alkali than that of the lower layer.

Further, the infrared absorbing dye may be added to any one of the layers, or may be added to the both layers. Regarding the infrared absorbing dyes, different infrared absorbing dyes may be added to respective layers, or infrared absorbing dyes of plural compounds may be added to each layer. Concerning the amount of the infrared absorbing dye to be contained, in the case of adding the infrared absorbing dye to any one of the layers, the infrared absorbing dye may be added, as described above, at a proportion of from 0.01% by mass to 50% by mass, preferably from 0.1% by mass to 50% by mass, and particularly preferably from 0.1% by mass to 30% by mass, with respect to the total solids content of the layer to be added. When the infrared absorbing dye is added to plural layers, it is preferable that the total addition amount falls within the above ranges.

It is preferable to provide an undercoat layer between the thermal positive type image recording layer and the support. As the components incorporated in the undercoat layer, various organic compounds described in paragraph [0068] of JP-A No. 2001-305722 may be exemplified.

### [Support]

As the hydrophilic support used for the planographic printing starting plate, a plate-like substance that has a required strength and durability and is dimensionally stable is described, and examples of the support include paper; paper laminated with a plastic (for example, polyethylene, polypropylene, polystyrene, or the like); a metal plate (for example, aluminum, zinc, copper, or the like); a plastic film (for example, cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate, polyvinyl acetal, or the like); paper or a plastic film, each of which is laminated with a metal as described above; and paper or a plastic film, on which a metal as described above has been vapor-deposited. Among them, a polyester film and an aluminum plate are preferable, and an aluminum pate is particularly preferable because of its good dimensional stability and relatively low cost.

The thickness of the aluminum plate used for the support is from about 0.1 mm to about 0.6 mm, preferably from 0.15 mm to 0.4 mm, and particularly preferably from 0.2 mm to 0.3 mm.

The aluminum plate is subjected to various surface treatments, whereby a support is formed. Surface treatments are conducted for the purposes of enhancing the surface hydrophilicity, enhancing the adhesion with the image recording layer, and the like, and include a surface roughening treatment, for example, a mechanical roughening treatment, an electrochemical roughening treatment, or a chemical roughening treatment.

The aluminum plate thus roughened is subjected to an alkali etching treatment and a neutralizing treatment, as required. Thereafter, the resulting aluminum plate is subjected to an anodic oxidization treatment, as desired, for enhancing the water-holding property or abrasion resistance of the surface.

Further, a hydrophilization treatment is performed, as required. With regard to the hydrophilization treatment, an alkaline metal silicate (for example, an aqueous solution of sodium silicate) method as disclosed in U.S. Patent Nos. 2,714,066, 3,181,461, 3,280,734 and 3,902,734, a method of processing with polyvinyl phosphonic acid as disclosed in U.S. Patent Nos. 3,276,868, 4,153,461, and 4,689,272, or the like is used.

The planographic printing starting plate used in the present invention has, on a support, at least the above-described image recording layer, but it is possible to provide an undercoat layer between the support and the image recording layer, as necessary.

As the components of the undercoat layer, various kinds of organic compounds are used. Examples of the organic compounds include carboxymethyl cellulose, dextrin, gum arabic, phosphonic acids having an amino group such as 2-aminoethylphosphonic acid, organic phosphonic acids, which may have a substituent, such as phenylphosphonic acid, naphthylphosphonic acid, or alkylphosphonic acid, organic phosphinic acids, which may have a substituent, such as phenylphosphinic acid or alkylphosphinic acid, amino acids such as glycine or β-alanine, and hydrochlorides of amines having a hydroxyl group such as triethanolamine hydrochloride. These organic compounds may be used by mixing two or more of them.

The coating amount of the undercoat layer is suitably from 2 mg/m² to 200 mg/m², and preferably from 5 mg/m² to 100 mg/m².

The planographic printing starting plate prepared as described above is subjected to imagewise exposure, followed by development processing using the alkali development processing solution which is described above in detail.

Examples of a light source of actinic light rays, which may be used in the imagewise exposure, include a mercury lamp, a metal halide lamp, a xenon lamp, a chemical lamp, and a carbon arc lamp. Radiations include electron beams, X-rays, ion beams, and far infrared rays. Further, g-line, i-line, a deep-UV light, high density energy beams (laser beams) are also used. Examples of the laser beams include helium-neon laser, argon laser, krypton laser, helium-cadmium laser, and KrF excimer laser. In the present invention, light sources having an emission wavelength in the near infrared to infrared region are preferable, and a solid laser and a semiconductor laser are particularly preferable.

### <Others>

While the present invention is described with reference to examples of the invention, the invention is not at all limited to the above examples, and it will be apparent that the invention may be carried out in various ways without departing from the scope of the invention.

For example, although a configuration in which a heat pump circuit is used for the waste solution heating means and the water vapor cooling means is described as an example in the above exemplary embodiments, the present invention is not limited to this configuration. It is possible to apply the present invention to a configuration in which, for example, an electric heater is used for the heating means and a water-cooling cooler or the like is used for the heating means.

Further, the present invention is also applicable to a method for processing waste solution other than the waste solution in the plate-making process of a photosensitive planographic printing plate, as long as the waste solution has physical properties substantially similar to those of the waste solution according to the present invention and produces a concentrate.

## Claims

1. A method for processing waste solution in a plate-making process of a photosensitive planographic printing plate, which is discharged when the plate-making process is carried out using a developer for a photosensitive planographic printing plate,
the method comprising:
evaporating and concentrating the waste solution using an evaporative concentration apparatus to separate the waste solution into water vapor and a dissolved component,
heating the waste solution in the plate-making process by a heating means in an evaporation container having a base resistance;
taking out the water vapor separated from the waste solution in the plate-making process from the evaporation container, and condensing the water vapor in a cooling means, to turn the water vapor into reclaimed water, and
applying pressure, using a pump, to a concentrate of the waste solution in the plate-making process, which has been concentrated by evaporative concentration, and collecting the concentrate in a recovery tank, wherein
the developer for a photosensitive planographic printing plate comprises at least one sugar selected from non-reducing sugars and at least one base.

2. The method for processing waste solution in the plate-making process of a photosensitive planographic printing plate according to claim 1, the method comprising reducing the pressure inside the evaporation container using a pressure-reducing means, thereby heating and concentrating the waste solution in the plate-making process.

3. The method for processing waste solution in the plate-making process of a photosensitive planographic printing plate according to claim 1 or claim 2, wherein a heat pump is used as the heating means, and while the waste solution in the plate-making process is heated at a heat radiating portion of the heat pump, the water vapor in the cooling means is cooled at a heat absorbing portion of the heat pump.

4. The method for processing waste solution in the plate-making process of a photosensitive planographic printing plate according to any one of claim 1 to claim 3, the method further comprising neutralizing the waste solution in the plate-making process by lowering the pH.

## Patentansprüche

1. Verfahren zur Bearbeitung einer Abwasserlösung bei einem Plattenerzeugungsverfahren einer lichtempfindlichen Flachdruckplatte, die abgelassen wird, wenn das Plattenerzeugungsverfahren unter Verwendung eines Entwicklers für eine lichtempfindliche Flachdruckplatte durchgeführt wird,
wobei das Verfahren enthält:
Verdampfen und Konzentrieren der Abwasserlösung unter Verwendung einer Verdampfungs-Konzentrations-Anlage zum Trennen der Abwasserlösung in Wasserdampf und eine aufgelöste Komponente,
Erwärmen der Abwasserlösung in dem Plattenerzeugungsverfahren durch ein Erwärmungsmittel in einem Verdampfungsbehälter mit einer Basenresistenz,
Herausnahme des Wasserdampfes, der von der Abwasserlösung in dem Plattenerzeugungsverfahren getrennt ist, von dem Verdampfungsbehälter und Kondensieren des Wasserdampfes in einer Kühlvorrichtung, um den Wasserdampf in aufbereitetes Wasser umzuwandeln und
Auferlegung von Druck unter Verwendung einer Pumpe auf ein Konzentrat der Abwasserlösung in dem Plattenerzeugungsverfahren, das durch Verdampfungs-Konzentration konzentriert ist, und Sammeln des Konzentrates in einem Wiedergewinnungsbehälter, worin
der Entwickler für eine lichtempfindliche Flachdruckplatte zumindest einen Zucker enthält, ausgewählt aus nicht-reduzierenden Zuckern und zumindest eine Base.

2. Verfahren zur Bearbeitung einer Abwasserlösung beim Plattenerzeugungsverfahren einer lichtempfindlichen Flachdruckplatte nach Anspruch 1, wobei das Verfahren das Reduzieren des Drucks im Inneren des Verdampfungsbehälters unter Verwendung eines Druckreduktionsmittels enthält, wodurch die Abwasserlösung in dem Plattenerzeugungsverfahren erwärmt und konzentriert wird.

3. Verfahren zur Bearbeitung einer Abwasserlösung beim Plattenerzeugungsverfahren einer lichtempfindlichen Flachdruckplatte nach Anspruch 1 oder 2, worin eine Wärmepumpe als Erwärmungsmittel verwendet wird, und worin, während die Abwasserlösung im Plattenerzeugungsverfahren bei einem wärmeabstrahlenden Bereich der Wärmepumpe erwärmt wird, der Wasserdampf in der Kühlvorrichtung bei einem Wärmeabsorptionsbereich der Wärmepumpe gekühlt wird.

4. Verfahren zur Bearbeitung einer Abwasserlösung beim Plattenerzeugungsverfahren einer lichtempfindlichen Flachdruckplatte nach einem der Ansprüche 1 bis 3, wobei das Verfahren weiterhin das Neutralisieren der Abwasserlösung im Plattenerzeugungsverfahren durch Erniedrigung des pH enthält.

## Revendications

1. Procédé de traitement de solution résiduelle dans un processus de fabrication de plaque d'une plaque d'impression planographique photosensible, qui est rejetée quand le processus de fabrication de plaque est réalisé en utilisant un révélateur pour une plaque d'impression planographique photosensible, le procédé comprenant :
l'évaporation et la concentration de la solution résiduelle en utilisant un appareil de concentration par évaporation pour séparer la solution résiduelle en vapeur d'eau et en un composant dissous,
le chauffage de la solution résiduelle dans le processus de fabrication de plaque par un moyen de chauffage dans un récipient d'évaporation ayant une résistance de base ;
le prélèvement de la vapeur d'eau séparée de la solution résiduelle dans le processus de fabrication de plaque hors du récipient d'évaporation, et la condensation de la vapeur d'eau dans un moyen de refroidissement, pour transformer la vapeur d'eau en eau recyclée, et
l'application d'une pression, en utilisant une pompe, sur un concentré de la solution résiduelle dans le processus de fabrication de plaque, qui a été concentré par concentration par évaporation, et la collecte du concentré dans un récipient de récupération, dans lequel
le révélateur pour une plaque d'impression planographique photosensible comprend au moins un sucre choisi parmi des sucres non réducteurs et au moins une base.

2. Procédé de traitement de solution résiduelle dans le processus de fabrication de plaque d'une plaque d'impression planographique photosensible selon la revendication 1, le procédé comprenant la réduction de la pression à l'intérieur du récipient d'évaporation en utilisant un moyen de réduction de pression, en permettant ainsi de chauffer et de concentrer la solution résiduelle dans le processus de fabrication de plaque.

3. Procédé de traitement de solution résiduelle dans le processus de fabrication de plaque d'une plaque d'impression planographique photosensible selon la revendication 1 ou la revendication 2, dans lequel une pompe à chaleur est utilisée comme moyen de chauffage, et alors que la solution résiduelle dans le processus de fabrication de plaque est chauffée au niveau d'une section de rayonnement de chaleur de la pompe à chaleur, la vapeur d'eau dans le moyen de refroidissement est refroidie au niveau d'une section d'absorption de chaleur de la pompe à chaleur.

4. Procédé de traitement de solution résiduelle dans le processus de fabrication de plaque d'une plaque d'impression planographique photosensible selon l'une quelconque de la revendication 1 à la revendication 3, le procédé comprenant en outre la neutralisation de la solution résiduelle dans le processus de fabrication de plaque en abaissant le pH.
